# EUROPÄISCHE PATENTSCHRIFT

(11) **EP 2 717 341 B1**
(45) Veröffentlichungstag und Bekanntmachung des Hinweises auf die Patenterteilung: **12.12.2018**
(21) Anmeldenummer: 13187053.7
(22) Anmeldetag: 02.10.2013
(51) Int. Cl.: H01L 39/14

(54) **Supraleiterstruktur mit verketteten Bandstücken, die jeweils von unmittelbar aufeinanderfolgenden, weiteren Bandstücken überlappt werden**
Superconducting structure using concatenated strip sections, each of which are directly overlapped by subsequent strip sections
Structure supraconductrice avec pièces de ruban concaténées chevauchées respectivement par d'autres pièces de ruban successives

(30) Priorität: 05.10.2012 DE 102012218251
(43) Veröffentlichungstag der Anmeldung: 09.04.2014
(73) Patentinhaber: Bruker HTS GmbH, 63450 Hanau (DE)
(72) Erfinder: Schlenga, Klaus, 76351 Linkenheim-Hochstetten (DE); Usoskin, Alexander, 63456 Hanau (DE)
(74) Vertreter: Kohler Schmid Möbus Patentanwälte

(56) Entgegenhaltungen:
- EP-A1- 2 192 629
- DE-T2- 60 031 784
- DE-T2- 60 226 280
- US-A- 5 358 929
- US-A- 6 121 205
- US-A1- 2003 213 611

## Beschreibung

Die Erfindung betrifft eine Supraleiterstruktur, umfassend mehrere Bandstücke von bandförmigem Supraleiter,
wobei jedes Bandstück ein Substrat und eine darauf abgeschiedene supraleitende Schicht aufweist,
und wobei die Bandstücke mit einander zugewandten supraleitenden Schichten miteinander verbunden sind.

Eine solche Supraleiterstruktur ist beispielsweise aus der US 2005/0173679 A1 bekannt geworden.

Supraleiter können elektrische Ströme praktisch ohne ohmsche Verluste tragen. Sie werden insbesondere dort, wo hohe elektrische Stromstärken benötigt werden, eingesetzt, etwa in Magnetspulen.

Supraleiter können den elektrischen Strom nur unterhalb einer kritischen Temperatur (auch Sprungtemperatur genannt) verlustfrei übertragen. Oberhalb dieser Temperatur geht der Supraleiter in einen normalleitenden Zustand über.

Als Drähte verarbeitbare, metallische Supraleitermaterialien, wie NbTi, haben relativ niedrige Sprungtemperaturen, NbTi etwa um 9K, so dass ihr Einsatz, insbesondere in Bezug auf die erforderliche Kühlung, recht teuer ist. Desweiteren haben metallische Supraleiter auch relativ niedrige kritische Magnetfelder oberhalb derer sie ihre supraleitende Eigenschaft verlieren.

Hochtemperatursupraleiter (HTSL), wie Yttrium Barium Kupferoxid (YBCO), haben deutlich höhere Sprungtemperaturen, YBCO etwa um 90K, sind aber aufgrund ihrer keramischen Eigenschaften schwer zu verarbeiten. Werden sie bei Temperaturen deutlich unterhalb ihre Sprungtemperatur eingesetzt, können HTSL vergleichsweise große Stromstärken übertragen, d.h. sie weisen eine hohe kritische Stromdichte auf. Mit ihren vergleichsweise hohen kritischen Magnetfeldstärken eignen sich diese Materialien desweiteren auch bei tiefen Betriebstemperaturen zum Einsatz in starken Magnetfeldern.

Üblicherweise werden für technische Anwendungen HTSL auf bandförmigen, meist metallischen Substraten als eine dünne Schicht abgeschieden, wobei in der Regel eine oder mehrere Pufferschichten zwischen dem Substrat und der supraleitenden Schicht vermittelt und eine oder mehrere metallische Abschlussschichten über der supraleitenden Schicht abgeschieden werden. Diese Bauform wird auch als bandförmiger Supraleiter bezeichnet; im Englischen hat sich dafür das Schlagwort "coated conductor" (beschichteter Leiter) etabliert.

Die Abscheidung von supraleitenden Schichten guter Qualität ist jedoch relativ schwierig. In der Regel sind besonders texturierte Substratoberflächen erforderlich, die nur über begrenzte Längen zur Verfügung gestellt werden können. Derzeit sind qualitativ gute Bandstücke von bandförmigen Supraleitern auf einen Bereich von maximal ca. 100 bis 200 m begrenzt.

In der EP 0 545 608 A2 wurde vorgeschlagen, Leiterstücken, die nur in begrenzter Länge in guter Qualität gefertigt werden können, aneinander zu fügen, um einen supraleitenden Strom auch über längere Strecken, etwa einige Kilometer, transportieren zu können.

Aus der US 2005/0173679 A1 ist es bekannt geworden, zwei Bandstücken von bandförmigen Supraleiter miteinander zu verbinden, wobei die supraleitenden Schichten auf den jeweiligen Substraten einander zugewandt sind. Die supraleitenden Schichten sollen in supraleitendem Kontakt stehen, und durch die Nähe der beiden polykristallinen supraleitenden Schichten soll die effektive Korngrenzfläche erhöht und damit der kritische Strom verbessert werden.

US 6,828,507 B1 ist es ebenfalls bekannt geworden, zwei Bandstücken von bandförmigen Supraleiter miteinander zu verbinden, wobei die supraleitenden Schichten auf den jeweiligen Substraten einander zugewandt sind. Die supraleitenden Schichten werden über eine oder mehrere normalleitende Zwischenschichten (etwa Deckschichten der einzelnen Bandstücke) verbunden.

Aus der EP2192629 ist es bekannt dass einander zugewandten supraleitende Schichten von miteinander verbundenen Bandstücken, die Metalsubstrate beinhalten, durch eine oder mehrere normalleitende Schichten miteinander verbunden sind.

### Aufgabe der Erfindung

Der Erfindung liegt die Aufgabe zugrunde, eine Supraleiterstruktur zur Verfügung zu stellen, die eine hohe Stromtragfähigkeit aufweist und auch für große Strecken gut geeignet ist.

### Kurze Beschreibung der Erfindung

Diese Aufgabe wird gelöst durch eine Supraleiterstruktur gemäß Anspruch 1.

Die Erfindung sieht vor, dass mehrere der Bandstücke jeweils als ein verkettetes Bandstück ausgebildet sind,
wobei ein verkettetes Bandstück jeweils mit zwei weiteren Bandstücken derart verbunden ist, dass die supraleitenden Schichten der beiden weiteren Bandstücke einerseits und des verketteten Bandstücks andererseits einander zugewandt sind, und dass die weiteren Bandstücke zusammen im Wesentlichen mit der gesamten Länge des verketteten Bandstücks überlappen.

Die erfindungsgemäße Supraleiterstruktur weist eine besonders hohe Stromtragfähigkeit auf. Elektrischer Strom kann zwischen den einander gegenüberliegenden Bandstücken ausgetauscht werden. Im Falle von Inhomogenitäten der kritischen Stromdichte (etwa normalleitende Fehlerbereiche in einer supraleitenden Schicht) in einem der Bandstücke werden diese durch das jeweils gegenüberliegende Bandstück überbrückt und umgekehrt, so dass es durch solche Inhomogenitäten zu keiner merklichen Beeinträchtigung der Stromtragfähigkeit der Supraleiterstruktur insgesamt kommt.

Weiterhin sind die Kontaktflächen zwischen den gegenüberliegenden Bandstücken sehr groß: Im Rahmen der vorliegenden Erfindung wird praktisch die gesamte Länge eines verketteten Bandstücks für den transversalen Stromaustausch genutzt, wodurch der Kontaktwiderstand sehr klein wird. Damit ist es möglich, zwischen den sich gegenüberliegenden, supraleitenden Schichten eine oder mehrere Schichten aus normalleitendem Material vorzusehen, ohne dass der ohmsche Widerstand dadurch merklich ansteigt. Gleichwohl sollten diese normalleitenden Schichten aus Materialien von guter elektrischer Leitfähigkeit (etwa Edelmetalle oder Kupfer oder deren Legierungen) gefertigt sein, und die Dicke der Schichten sollte relativ gering sein. Diese Zwischenschichten können den Herstellungsprozess der Supraleiterstruktur vereinfachen und auch als Wärmeleiter und parallele Strompfade zu den supraleitenden Schichten zur Stabilisierung der Supraleitung und als Quenchschutz hilfreich sein. Entsprechend sieht die Erfindung vor, dass einander zugewandte supraleitende Schichten von miteinander verbundenen Bandstücken durch eine oder mehrere edelmetallhaltige Schichten, insbesondere silberhaltige Schichten, und/oder eine oder mehrere kupferhaltige Schichten, insbesondere Kupferschichten, miteinander verbunden sind. Durch die Verbindung über eine normalleitende Schicht (oder mehrere solche Schichten) ist die Herstellung der Supraleiterstruktur vereinfacht, und die Schichten können funktionell (etwa zur Stabilisierung und als Quenchschutz) eingesetzt werden. Aufgrund der großen Kontaktflächen tritt durch die normalleitende Schicht (oder mehrere solcher Schichten) bei geeigneter Materialwahl (etwa ausreichend guter elektrischer Leitfähigkeit) und geeigneter Schichtdickenwahl (nicht zu dick) nur ein vernachlässigbarer ohmscher Widerstand auf.

Im Rahmen der Erfindung ist es möglich, auch bei Verkettung einer großen Zahl von Bandstücken hintereinander keine merklichen ohmschen Leitungswiderstände aufzubauen. Dadurch ist die Erfindung auch für eine Stromübertragung über große Strecken, etwa im Kilometerbereich, gut geeignet.

Die weiteren Bandstücke, mit denen ein verkettetes Bandstück gemäß der Erfindung verbunden ist, können ihrerseits verkettete Bandstücke sein; dadurch können praktisch beliebige Streckenlängen mit der erfindungsgemäßen Supraleiterstruktur aufgebaut werden. Bei der erfindungsgemäßen Supraleiterstruktur umfasst die Supraleiterstruktur wenigstens N aufeinanderfolgende, verkettete Bandstücke, mit N ≥ 5, bevorzugt N ≥ 20, derart, dass zumindest eines der weiteren Bandstücke zu einem jeden der aufeinanderfolgenden, verketteten Bandstücke seinerseits eines der aufeinanderfolgenden, verketteten Bandstücke ist. Erfindungsgemäß kann somit die Supraleiterstruktur unter Nutzung ihrer Vorteile auf beliebigen, insbesondere auch großen Längen genutzt werden. Für alle (bezüglich der Erstreckungsrichtung) inneren Bandstücke der aufeinanderfolgenden, verketteten Bandstücke sind beide weiteren Bandstücke jeweils verkettete Bandstücke, und für die beiden äußeren Bandstücke der aufeinanderfolgenden, verketteten Bandstücke ist lediglich eines der weiteren Bandstücke ein verkettetes Bandstück. Die Supraleiterstruktur umfasst grundsätzlich Bandstücke in zwei Ebenen (obere und untere Ebene). Die verketteten Bandstücke in der oberen Ebene sind hintereinander angeordnet und mit ihren supraleitenden Schichten nach unten orientiert, und die verketteten Bandstücke in der unteren Ebene sind ebenfalls hintereinander angeordnet, jedoch mit ihren supraleitenden Schichten nach oben orientiert.

Erfindungsgemäß überlappen die beiden weiteren Bandstücke zusammen mit wenigstens 95%, bevorzugt wenigstens 99% der gesamten Länge eines verketteten Bandstücks. Dadurch kann eine sehr große Kontaktfläche zwischen den überlappenden Bandstücken und ein entsprechend geringer elektrischer Widerstand erreicht werden. Eine etwaige verbleibende (nicht-überlappte) Länge des verketteten Bandstücks entfällt typischerweise auf einen Spalt zwischen den weiteren Bandstücken, und/oder auf Ein- oder Ausleitestellen für den elektrischen Strom (dann meist an den Enden der Supraleiterstruktur).

Weiterhin ist vorgesehen, dass die verketteten Bandstücke jeweils eine Länge von wenigstens 100 m, bevorzugt wenigstens 200 m, aufweisen. Dies stellt zum einen auch sicher, dass auch die Überlappungslängen mit den weiteren Bandstücken groß sind (meist ca. die Hälfte der Länge des verketteten Bandstücks je weiterem Bandstück), zum anderen kann mit solch großen Bandstücklängen effizient eine große Gesamtlänge der Supraleiterstruktur eingerichtet werden.

Zudem weist die Supraleiterstruktur eine Gesamtlänge von wenigstens 1000 m, bevorzugt wenigstens 2000 m auf. Die erfindungsgemäße Supraleiterstruktur kann solche großen Gesamtlängen ohne weiteres bereitstellen; die Vorteile der Erfindung kommen dann besonders gut zur Geltung.

Die Verbindung zweier Bandstücke mit einander zugewandten (gegenüberliegenden) supraleitenden Schichten bewirkt im Rahmen der Erfindung einen quasi-supraleitenden elektrischen Kontakt, so dass zumindest an der Überlappung insgesamt ein verschwindender ohmscher Widerstand auftritt.

### Bevorzugte Ausführungsformen der Erfindung

Bei einer bevorzugten Ausführungsform ist die Supraleiterstruktur über die aufeinanderfolgenden, verketteten Bandstücke in Erstreckungsrichtung der Bandstücke periodisch ausgebildet. Dies macht den Aufbau besonders einfach; insbesondere können Bandstücke gleicher Länge verbaut werden.

Bevorzugt ist auch eine Ausführungsform, bei der die Supraleiterstruktur zwei randseitige Bandstücke aufweist, wobei ein randseitiges Bandstück jeweils mit einem verketteten Bandstück derart verbunden ist, dass die supraleitenden Schichten des randseitigen Bandstücks einerseits und des verketteten Bandstücks andererseits einander zugewandt sind, und dass das verkettete Bandstück im Wesentlichen mit der gesamten Länge des randseitigen Bandstücks überlappt. Mit den randseitigen Bandstücken kann die Supraleiterstruktur an ihren beiden Enden (vorderes und hinteres Ende) abgeschlossen werden. Die randseitigen Bandstücke können in derselben Ebene oder auch in verschiedenen Ebenen angeordnet sein. Typischerweise überlappt das verkettete Bandstück mit wenigstens 95%, bevorzugt wenigstens 99% oder auch 100% der Länge des randständigen Bandstücks.

Bei einer vorteilhaften Ausführungsform weist ein Spalt zwischen zwei weiteren Bandstücken, die mit demselben verketteten Bandstück verbunden sind, eine Spaltbreite in Erstreckungsrichtung der Bandstücke von 5mm oder weniger, bevorzugt 2mm oder weniger auf, insbesondere wobei der Spalt bei aneinander anstoßenden weiteren Bandstücken geschlossen ausgebildet ist. Durch eine geringe oder gar verschwindende Spaltbreite ist es sehr unwahrscheinlich, dass eine Inhomogenität der kritischen Stromdichte im verketteten Bandstück gerade unter dem Spalt lokalisiert ist.

Bevorzugt ist auch eine Ausführungsform, bei der ein Spalt zwischen zwei weiteren Bandstücken, die mit demselben verketteten Bandstück verbunden sind, näherungsweise mittig bezüglich der Länge dieses verketteten Bandstücks angeordnet ist. Durch die mittige Spaltanordnung steht für die Kontaktflächen zu den weiteren Bandstücken näherungsweise die gleiche Teillänge zur Verfügung, wodurch eine einseitige Erhöhung des Kontaktwiderstands zu einem der weiteren Bandstücke vermieden wird. Typischerweise weicht die Spaltposition maximal 10%, bevorzugt maximal 5%, von der Mitte des verketteten Bandstücks ab, bezogen auf die Länge des verketteten Bandstücks.

Bei einer vorteilhaften Ausführungsform der erfindungsgemäßen Supraleiterstruktur ist vorgesehen, dass die einander gegenüberliegenden Enden von zwei weiteren Bandstücken, die mit demselben verketteten Bandstück verbunden sind, sich jeweils auf das andere weitere Bandstück zu verjüngen, insbesondere so dass ein Spalt zwischen diesen zwei weiteren Bandstücken zumindest abschnittsweise mit einem Winkel zwischen 5° und 30° zur Erstreckungsrichtung der Bandstücke verläuft. Bei dieser Variante verläuft der Spalt zwischen den weiteren Bandstücken zumindest abschnittsweise schräg (und insbesondere nicht senkrecht) zur Erstreckungsrichtung des verketteten Bandstücks. Der Spalt zieht sich über eine erhebliche Strecke (in Erstreckungsrichtung des verketteten Bandstücks) hin, nimmt aber nirgends die volle Breite des Supraleiterstruktur ein. Dadurch können Inhomogenitäten des kritischen Stroms, die meist nicht über die volle Breite einer supraleitenden Schicht ausgedehnt sind (vgl. typische Bandbreiten von zwischen 2 mm und 6 cm) regelmäßig gut überbrückt werden, selbst wenn sie in Spaltnähe lokalisiert sind.

Vorteilhaft ist weiterhin eine Ausführungsform, bei der die Bandstücke der Supraleiterstruktur außenseitig mit einer Shunt-Struktur versehen sind, insbesondere teilweise oder vollständig von einer Shunt-Schicht umhüllt sind. Dadurch wird ein normalleitender Strompfad parallel zu den supraleitenden Schichten zur Verfügung gestellt, über die im Falle eines plötzlichen Zusammenbruchs der Supraleitung ("Quench") der zuvor supraleitend getragene elektrische Strom übernommen werden kann. Dadurch wird eine Überhitzung ("Durchbrennen") der supraleitenden Schichten vermieden. Die Shunt-Struktur kann insbesondere aus Kupfer gefertigt sein.

Bei einer bevorzugten Weiterbildung dieser Ausführungsform ist vorgesehen, dass jeweils zwei Bandstücke, die mit einander zugewandten supraleitenden Schichten miteinander verbunden sind, quer zur Erstreckungsrichtung der Bandstücke in einem oder mehreren Überstandbereichen nicht überlappen, und dass die Shunt-Struktur in mindestens einem besagten Überstandbereich das zugehörige Bandstück kontaktiert. Dadurch ist die Ausleitung des elektrischen Stroms aus den supraleitenden Schichten der Bandstücke im Quenchfall besonders einfach. Zwei Überstandbereiche können aufgrund eines Versatzes von gleich breiten Bandstücken quer zur Erstreckungsrichtung der Bandstücke entstehen; ein oder zwei Überstandbereiche können durch Verwendung unterschiedlich breiter Bandstücke entstehen.

Besonders bevorzugt ist auch eine Ausführungsform, bei der die supraleitende Schicht ein Hochtemperatur-Supraleitermaterial, insbesondere YBCO oder BSCCO, enthält. Mit HTSL-Material kann bei höheren Temperaturen (etwa mit LN₂-Kühlung) operiert werden, was Unterhaltskosten spart, oder es können besonders hohe Stromtragfähigkeiten (bei tieferen Temperaturen, etwa mit LHe-Kühlung) erreicht werden. Als HTSL-Materialien im Rahmen der Erfindung gelten alle Materialien mit einer Sprungtemperatur oberhalb von 40K. BSCCO-Materialien können Bi₂Sr₂CaCu₂O₈₊ₓ und/oder Bi₂Sr₂Ca₂Cu₃O₁₀₊ₓ umfassen.

Ebenfalls vorteilhaft ist eine Ausführungsform, bei der zwischen Substrat und supraleitender Schicht eine Pufferschicht, insbesondere enthaltend CeO2, angeordnet ist. Dadurch kann die Qualität der supraleitenden Schicht verbessert werden. Gegebenenfalls können auch mehrere Pufferschichten eingesetzt werden.

Es ist möglich, ein Verfahren zum Transport eines elektrischen Stroms entlang einer erfindungsgemäßen, oben beschriebenen Supraleiterstruktur umfassend mehrere Bandstücke von bandförmigem Supraleiter anzuwenden,
wobei jedes Bandstück ein Substrat und eine darauf abgeschiedene supraleitende Schicht aufweist,
und wobei der Strom zwischen den Bandstücken wechselt, wofür transversaler Strom fließt,
wobei transversaler Strom im Wesentlichen über die gesamte Länge der Supraleiterstruktur fließt, mit Ausnahme von lokalen Bereichen
- von Spalten zwischen in der gleichen Ebene der Supraleiterstruktur aufeinanderfolgenden Bandstücken und
- von Positionen einer lokalen Inhomogenität des kritischen Stroms. Durch die Einrichtung von transversalem Stromfluss über im Wesentlichen die gesamte Länge der Supraleiterstruktur sind Kontaktwiderstände zwischen den beteiligten Bandstücken minimiert. Man beachte, dass in vielen Flächenbereichen einer supraleitenden Schicht im Rahmen des Verfahrens durchaus netto ein transversaler Strom von "null" fließen kann, was jedoch nicht bedeutet, dass hier kein transversaler Stromfluss stattfindet, sondern nur, dass gleich viel transversaler Strom in die eine wie in die entgegengesetzte Richtung fließt; in solchen Flächenbereichen fließt durchaus transversaler Strom in Sinne des Verfahrens. An Spalten und Inhomogenitäten (etwa normalleitenden Fehlerbereichen in den supraleitenden Schichten der Bandstücke) weicht der transportierte elektrische Strom durch geeignete transversale Stromflüsse vor und hinter dem Spalt oder der Inhomogenität in ein überbrückendes Bandstück aus, so dass hohe Stromtragfähigkeiten der Supraleiterstruktur im Rahmen des Verfahrens erreicht werden. Man beachte, dass Spalten typischerweise sehr viel kleiner sind als die Länge eines Bandstücks, mit typischen Spaltbreiten von 5 mm oder weniger, bevorzugt 2 mm oder weniger, und Längen eines den Spalt überbrückenden Bandstücks von 100 m oder länger, bevorzugt 200 m oder länger.

In einer bevorzugten Variante des Verfahrens wechselt mehr als 99%, bevorzugt mehr als 99,999%, des entlang der Supraleiterstruktur transportierten elektrischen Stroms zwischen Bandstücken, die mit einander zugewandten supraleitenden Schichten miteinander verbunden sind. Gemäß der Variante wird der Strom ganz überwiegend in den supraleitenden Schichten transportiert, die an einem Wechsel des Stroms zwischen verschiedenen Bandstücken teilnehmen, wodurch die Vorteile der Erfindung besonders gut zur Geltung kommen.

Ebenfalls bevorzugt ist eine Variante, die vorsieht, dass an einem verketteten Bandstück, das zwei in einer Ebene aufeinanderfolgende weitere Bandstücke über einen zwischen diesen Bandstücken liegenden Spalt verbindet, der transversale Strom, der netto zu oder von den weiteren Bandstücken fließt, im Bereich eines ersten Endes des verketteten Bandstücks ein lokales Maximum hat, sodann im Bereich kurz vor einem Spalt der beiden weiteren Bandstücke ein weiteres lokales Maximum hat, sodann im Bereich kurz hinter dem Spalt der beiden weiteren Bandstücke ein lokales Minimum hat, und schließlich im Bereich des zweiten Endes des verketteten Bandstücks ein weiteres lokales Minimum hat, oder umgekehrt. Mit einem solches Profil des transversalen Stroms kann der transportierte Strom effizient vor einem Spalt ausweichen. Man beachte, dass bei schräg verlaufenden Spalten die Extrema in der Nähe eines Spalts meist flacher verlaufen.

Weitere Vorteile der Erfindung ergeben sich aus der Beschreibung und der Zeichnung. Ebenso können die vorstehend genannten und die noch weiter ausgeführten Merkmale erfindungsgemäß jeweils einzeln für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung laut Anspruch 1.

### Detaillierte Beschreibung der Erfindung und Zeichnung

Die Erfindung ist in der Zeichnung dargestellt und wird anhand von Ausführungsbeispielen näher erläutert. Es zeigen:
- Fig. 1: einen schematischen Längsschnitt durch einen periodischen Teil einer erfindungsgemäßen Supraleiterstruktur;
- Fig. 2: einen schematischen Längsschnitt durch eine erfindungsgemäße Supraleiterstruktur mit fünf verketteten Bandstücken und zwei randständigen Bandstücken;
- Fig. 3a: eine schematische Schrägansicht auf einen Teil einer erfindungsgemäßen Supraleiterstruktur im Bereich eines quer zur Erstreckungsrichtung verlaufenden Spalts;
- Fig. 3b: eine schematische Schrägansicht auf einen Teil einer erfindungsgemäßen Supraleiterstruktur im Bereich eines schräg zur Erstreckungsrichtung verlaufenden Spalts;
- Fig. 4a-4f: schematische Querschnitte durch verschiedene Ausführungsformen einer erfindungsgemäßen Supraleiterstruktur;
- Fig. 5: ein Diagramm schematisch darstellend den transversalen Strom durch ein verkettetes Bandstück einer erfindungsgemäßen Supraleiterstruktur als Funktion des Orts entlang der Erstreckungsrichtung der Supraleiterstruktur.

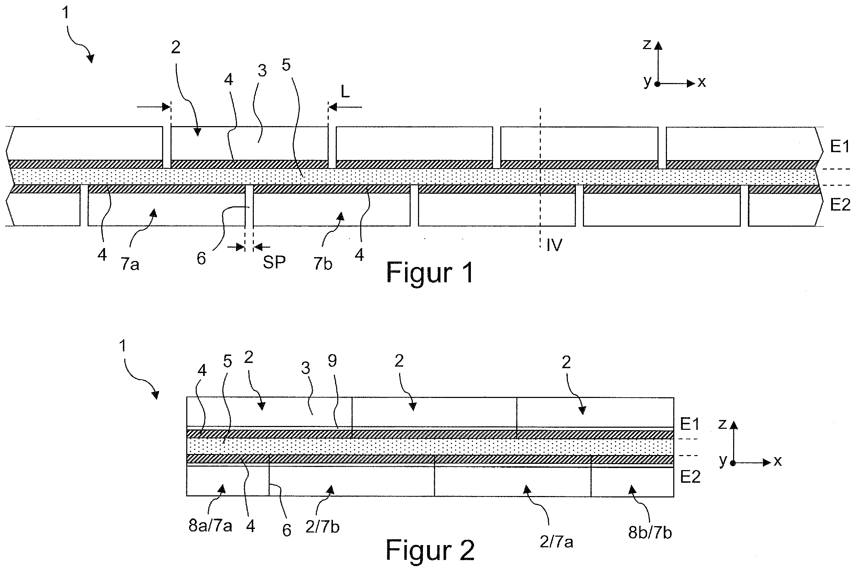

**Fig. 1** zeigt im schematischen Längsschnitt einen Ausschnitt aus einer erfindungsgemäßen Supraleiterstruktur 1. Die Supraleiterstruktur 1 weist eine Vielzahl an Bandstücken von bandförmigem Supraleiter auf, wobei der Ausschnitt der Figur nur so genannte verkettete Bandstücken 2 umfasst. Im Ausschnitt sind insgesamt elf aufeinanderfolgende, verkettete Bandstücke 2 teilweise oder ganz dargestellt (Zur Vereinfachung ist in der Figur nur eines der Bandstücke mit dem Bezugszeichen 2 markiert).

Jedes Bandstück 2 weist ein Substrat 3 (etwa aus Stahlblech) und eine auf dem Substrat 3 abgeschiedene, supraleitende Schicht 4 auf. Die Bandstücke 2 sind in zwei Ebenen E1, E2 angeordnet; die Bandstücken 2 in der oberen Ebene E1 sind mit ihren supraleitenden Schichten 4 nach unten (auf die untere Ebene E2 zu) orientiert, und die Bandstücke 2 in der unteren Ebene E2 sind mit ihren supraleitenden Schichten 4 nach oben (auf die obere Ebene E1 zu) orientiert. Zwischen den Bandstücken 2 der verschiedenen Ebenen E1, E2 ist eine Lotschicht 5, die hier aus einer silberhaltigen Legierung besteht, angeordnet.

Zwischen benachbarten Bandstücken 2 der gleichen Ebene E1, E2 liegt in der gezeigten Ausführungsform jeweils ein Spalt 6 mit gegenüber der Länge L der Bandstücken 2 sehr viel geringerer Spaltbreite SP. Die Supraleiterstruktur 1 ist in gezeigten Ausschnitt in Erstreckungsrichtung (x-Richtung) periodisch aufgebaut (sowohl in jeder Ebene E1, E2 als auch insgesamt); insbesondere weisen hier alle verketteten Bandstücke 2 die gleiche Länge L auf und die Spalten 6 die gleiche Spaltbreite SP.

Man beachte, dass in der Figur 1 (und auch in den nachfolgenden Figuren) keine maßstabsgetreuen Dimensionen zu sehen sind, sondern viele Strukturelemente vergrößert dargestellt sind, um deren Erkennbarkeit zu erleichtern. In Erstreckungsrichtung x der Supraleiterstruktur 1 haben die Bandstücken 2 je eine Länge L, wobei erfindungsgemäß L ≥ 100 m ist; Spaltbreiten SP (in x-Richtung) betragen typischerweise 5 mm oder weniger. Die Breite der Bandstücken 2 senkrecht zur Zeichenebene von Fig. 1 (y-Richtung) liegt typischerweise zwischen 2 mm und 6 cm, und die Höhe der Bandstücken 2 in z-Richtung liegt im Bereich 200 µm oder weniger, meist bei ca. 100 µm oder weniger. Die Dicke einer supraleitenden Schicht 4 (in z-Richtung) beträgt meist einige µm, und die Dicke einer typischen Lotschicht 5 liegt meist im Bereich 100 µm oder weniger, oft 25 µm oder weniger.

Die Supraleiterstruktur 1 dient dazu, einen elektrischen Strom in ihrer Erstreckungsrichtung x zu transportieren. Dafür sind die Bandstücke 2 als erfindungsgemäß verkettete Bandstücken 2 ausgebildet. Jedes verkettete Bandstück 2 überlappt in x-Richtung mit zwei weiteren Bandstücken 7a, 7b (die hier ihrerseits verkettete Bandstücke sind). Die Länge L des verketteten Bandstücks 2 wird dabei von den beiden Bandstücken 7a, 7b zusammen im Wesentlichen vollständig überlappt; lediglich im Bereich des Spalts 6 zwischen den weiteren Bandstücken 7a, 7b besteht in der gezeigten Ausführungsform keine Überlappung. Der Spalt 6 liegt mittig bezüglich des verketteten Bandstücks 2, so dass die Überlapplängen mit den Bandstücken 7a, 7b jeweils ungefähr L/2 betragen.

Ein in Erstreckungsrichtung der Supraleiterstruktur 1 (x-Richtung) zu transportierender elektrischer Strom im weiteren Bandstück 7a (bzw. dessen supraleitender Schicht 4) kann über eine sehr große Fläche in das verkettete Bandstück 2 übertreten (transversaler Stromfluss in z-Richtung), bevor der Spalt 6 einen weiteren Stromfluss in Erstreckungsrichtung blockiert. Der ohmsche Widerstand an diesem Übergang ist entsprechend gering. Im verketteten Bandstück 2 kann der Stromfluss dann den Spalt 6 passieren. Anschließend kann der Strom in ähnlicher Weise in das weitere Bandstück 7b übertreten, um den nächsten Spalt zu überbrücken, und so fort.

Die **Figur 2** zeigt ebenfalls in einem Längsschnitt eine erfindungsgemäße Supraleiterstruktur 1 mit genau fünf verketteten Bandstücken 2 und zwei randständigen Bandstücken 8a, 8b; die Supraleiterstruktur 1 erstreckt sich in x-Richtung. Die Spalte 6 zwischen den innerhalb der beiden Ebenen E1, E2 benachbarten Bandstücken 2, 8a, 8b weisen in dieser Ausführungsform eine verschwindende Spaltbreite (in x-Richtung) auf.

Die in der oberen Ebene E1 jeweils links und rechts äußeren, verketteten Bandstücke 2 sind mit ihren supraleitende Schichten 4 jeweils einem der randständigen Bandstück 8a, 8b und einem verketteten Bandstück 2 als weitere Bandstücke 7a, 7b zugewandt bzw. über die Lotschicht 5 mit diesen verbunden. Die randständigen Bandstücke 8a, 8b werden hier vom jeweils gegenüberliegenden, äußeren verketteten Bandstück 2 in x-Richtung vollständig überlappt.

In der gezeigten Ausführungsform ist auch eine Pufferschicht 9 der Bandstücke 2, 8a, 8b eingezeichnet, die beispielsweise CeO2 enthält, und jeweils zwischen dem Substrat 3 und der supraleitenden Schicht 4 angeordnet ist.

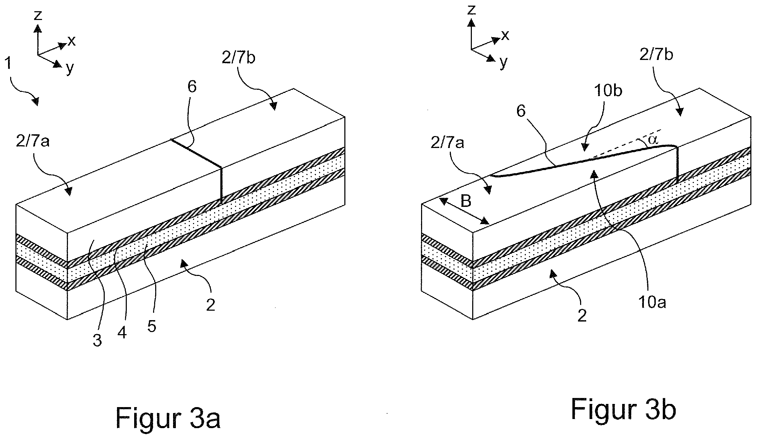

Die **Figur 3a** zeigt in einer schematischen Schrägansicht einen Ausschnitt aus einer erfindungsgemäßen Supraleiterstruktur 1, beispielsweise einer Supraleiterstruktur wie in Fig. 1 gezeigt, im Bereich eines Spalts 6 zwischen zwei in der oberen Ebene der Supraleiterstruktur 1 benachbarten, verketteten Bandstücken 2; diese beiden Bandstücke stellen weitere Bandstücke 7a, 7b zum Bandstück 2 in der unteren Ebene dar. In der gezeigten Ausführungsform verläuft der Spalt 6 quer zur (senkrecht zur) Erstreckungsrichtung x der Supraleiterstruktur 1; diese Spaltgeometrie ist besonders einfach herzustellen.

Es ist allerdings auch möglich, den Spalt 6 schräg zur Erstreckungsrichtung (x-Richtung) auszubilden, wie in der Supraleiterstruktur 1 von **Figur 3b** gezeigt. Die Enden 10a, 10b der Bandstücken 2 bzw. 7a, 7b in der oberen Ebene der Supraleiterstruktur 1 verjüngen sich hier jeweils in Richtung auf das jeweils andere Bandstück 2 bzw. 7b, 7a zu; die Enden 10a, 10b ergänzen sich aber im Wesentlichen zur vollen Breite B der beiden Bandstücke 2 bzw. 7a, 7b. Der verbleibende Spalt 6 verläuft größtenteils mit einem Winkel α von ca. 15° gegenüber der Erstreckungsrichtung x.

Man beachte, dass eine Spaltbreite SP im Rahmen der Erfindung stets in Erstreckungsrichtung x gemessen wird, auch wenn der Spalt 6 schräg zur Erstreckungsrichtung x verlaufen sollte. Falls die Spaltbreite entlang des Spalts 6 variieren sollte, bestimmt sich die Spaltbreite SP des Spalts insgesamt grundsätzlich nach der größten auftretenden Spaltbreite entlang des Spalts 6.

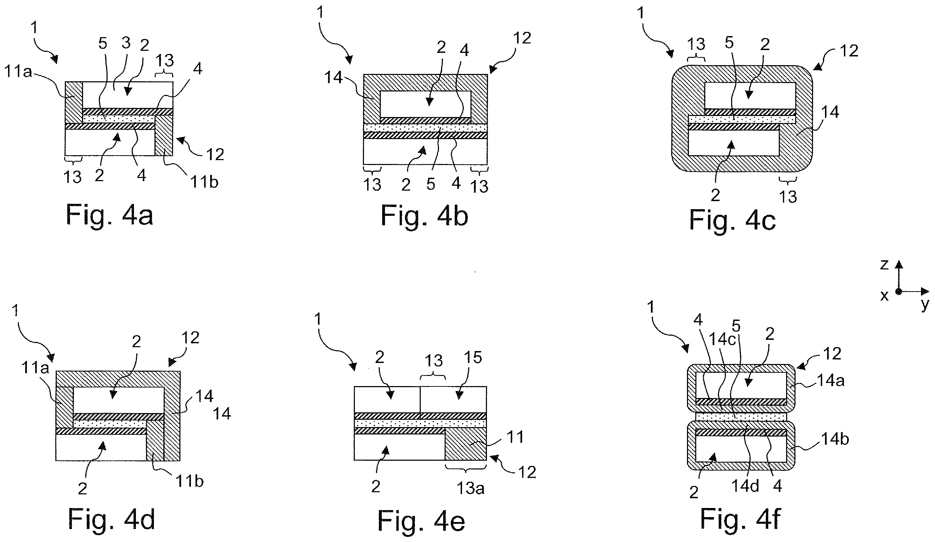

In den Figuren 4a bis 4f sind Querschnitte (vgl. die Ebene IV in Fig. 1) durch verschiedene Ausführungsformen von erfindungsgemäßen Supraleiterstrukturen 1 dargestellt, wobei der Querschnitt an einer Position entfernt von den Spalten gewählt ist.

Wie aus **Fig. 4a** ersichtlich, können die gegenüberliegenden, hier gleich breiten Bandstücke 2 einer erfindungsgemäßen Supraleiterstruktur 1 seitlich (in y-Richtung) gegeneinander versetzt angeordnet werden, so dass quer zur Erstreckungsrichtung x zwei Überstandbereiche 13 verbleiben. Diese werden mit zwei Shunt-Elementen 11a, 11b, die bevorzugt aus Kupfer gefertigt sind, kontaktiert, so dass zwei normalleitende Strompfade parallel zu den supraleitenden Schichten 4 eingerichtet sind und dadurch eine Shunt-Struktur 12 ausgebildet wird. Zwischen den supraleitenden Schichten 4 (hier nicht jedoch unter den Shunt-Elementen 11a, 11b) ist ein silberhaltiges Lot für einen guten elektrischen Kontakt vorgesehen.

In der Ausführungsform der Supraleiterstruktur 1 von **Fig. 4b** sind zwei unterschiedlich breite Bandstücke 2 verbaut. Das schmalere, obere Bandstück 2 ist mittig auf dem unteren, breiteren Bandstück 2 platziert und wird von einer Shunt-Schicht 14 umhüllt, die auch die Überstandbereiche 13 des unteren Bandstücks 13 bedeckt. In der gezeigten Ausführungsform kontaktiert die Shunt-Schicht 14 (die bevorzugt aus Kupfer gefertigt ist) dabei eine Lotschicht 5, wodurch ein guter elektrischer Kontakt zu beiden supraleitenden Schichten 4 sichergestellt ist. Dadurch kann die Shunt-Schicht 14 als Shunt-Struktur 12 für beide Bandstücke 2 gut eingesetzt werden.

In der Ausführungsform der Supraleiterstruktur von **Fig. 4c** sind die zwei gegenüberliegenden, aber seitlich gegeneinander verschobenen Bandstücke 2 vollständig von einer Shunt-Schicht 14 umhüllt, die entsprechend auch die Überstandbereiche 13 (hier über die Lotschicht 5) kontaktiert. Die Shunt-Schicht 14 agiert hier nicht nur als Shunt-Struktur 12, sondern auch als mechanische Klammer für die beiden Bandstücke 2.

Die **Fig. 4d** illustriert eine Variante der Ausführungsform von Fig. 4a, wobei eine zusätzliche Shunt-Schicht 14 L-förmig die beiden Shunt-Elemente 11a, 11b und das obere Bandstück 2 umgreift. Dadurch kann die Querschnittsfläche der gesamten Shunt-Struktur 12 erhöht werden.

Es ist auch möglich, ein in der **Fig. 4e** unten angeordnetes Bandstück 2 mit einem oberen Bandstück 2 seitlich in γ-Richtung nur teilweise zu überlappen, so dass ein Überstandbereich 13 verbleibt, und diesen Überstandbereich 13 mit einem Behelfsbandstück 15 zu kontaktieren. Das Behelfsbandstück 15 kann ein verkettetes Bandstück der Supraleiterstruktur 1 sein oder auch nicht. Mit dem Behelfsbandstück 15 wird ein Behelfsüberstandbereich 13a geschaffen, der mit einem Shunt-Element 11 kontaktiert werden kann, wobei die Breite (in γ-Richtung) des Behelfsüberstandbereichs 13a durch die Breite des Behelfsbandstücks 15 praktisch beliebig eingestellt werden kann. Dadurch kann die Leistungsfähigkeit der Shunt-Anordnung 12 eingestellt werden.

Weiterhin ist es möglich, eine Shunt-Anordnung 12 durch zwei Shunt-Schichten 14a, 14b (hier aus Kupfer) auszubilden, die jeweils für sich eines der beiden Bandstücke 2 umhüllen, und die beiden Shunt-Schichten 14a, 14b über eine Lotschicht 5 zu verbinden, vgl. **Fig. 4f****.** Dadurch liegen effektiv zwischen den einander gegenüberliegenden supraleitenden Schichten 4 der beiden Bandstücke 2 zwei Kupferschichten 14c, 14d und eine hier silberhaltige Lotschicht 5.

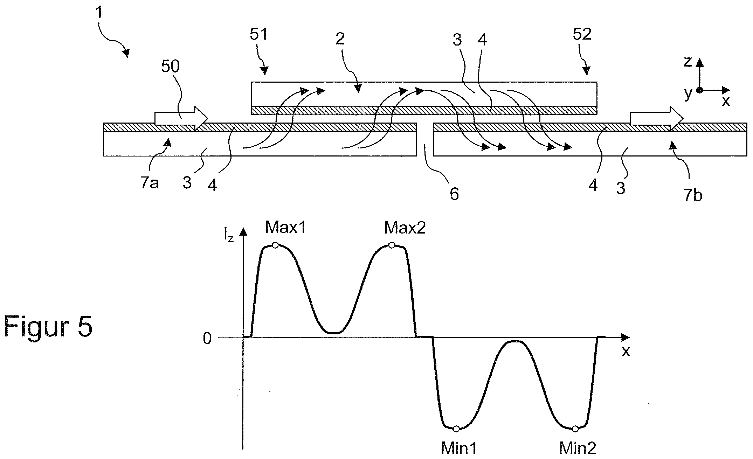

Die **Fig. 5** illustriert den Fluss von in einer erfindungsgemäßen Supraleiterstruktur 1 in Erstreckungsrichtung x transportiertem elektrischen Strom 50. Die Supraleiterstruktur 1 umfasst zumindest ein verkettetes Bandstück 2 und zwei mit diesem verbundene, weitere Bandstücke 7a, 7b, die insgesamt mit dem Bandstück 2 über dessen gesamte Länge in x-Richtung bis auf einen in γ-Richtung verlaufenden Spalt 6 überlappen. Im Diagramm ist der transversale Stromfluss l_{z}, also der Stromfluss in z-Richtung senkrecht in die supraleitende Schicht 4 des Bandstücks 2 hinein (bzw. bei negativem Vorzeichen aus dieser hinaus), als Funktion der x-Position dargestellt. Für eine bessere Übersichtlichkeit wurden die Bandstücke 2, 7a, 7b im oberen Teil der Figur etwas gespreizt dargestellt.

Der transversale Strom l_{z} hat zunächst in der Nähe des in der Fig. 5 linken Endes 51 des Bandstücks 2 ein Maximum Max1, da in diesem Bereich der von links durch das weitere Bandstück 7a fließende Strom erstmals auch das Bandstück 2 erreichen und nutzen kann. Vor dem Spalt 6 muss schließlich aller (verbliebene) Strom vom weiteren Bandstück 7a in das Bandstück 2 wechseln, was zu einem weiteren Maximum Max2 führt. Man beachte, dass Max1 und Max2 typischerweise gleich groß sind. Direkt über dem Spalt 6 zwischen den beiden weiteren Bandstücken 7a, 7b (die bezüglich z die gleiche Position haben, also in einer Ebene sind) ist kein transversaler Stromfluss möglich. Nach dem Spalt 6 kann erstmals Strom in das weitere Bandstück 7b fließen, was ein erstes Minimum Min1 des transversalen Stroms l_{z} zu Folge hat. Kurz vor dem rechten Ende 52 des Bandstücks 2 muss schließlich aller (verbliebene) Strom in das weitere Bandstück 7b wechseln, was an einem weiteren Minimum Min2 erkennbar ist.

In ähnlicher Weise wie ein Spalt 6 kann auch eine Inhomogenität des kritischen Stroms (etwa ein normalleitender Fehlerbereich in einer supraleitenden Schicht 4) vom Strom 50 umgangen werden.

Eine erfindungsgemäße Supraleiterstruktur kann insbesondere in supraleitenden Kabeln oder in supraleitenden Magnetspulen eingesetzt werden.

## Patentansprüche

1. Supraleiterstruktur (1), umfassend mehrere Bandstücke (2, 7a, 7b, 8a, 8b, 15) von bandförmigem Supraleiter,
wobei jedes Bandstück (2, 7a, 7b, 8a, 8b, 15) ein Substrat (3) und eine darauf abgeschiedene supraleitende Schicht (4) aufweist,
wobei die Bandstücke (2, 7a, 7b, 8a, 8b, 15) mit einander zugewandten supraleitenden Schichten (4) miteinander verbunden sind,
wobei einander zugewandte supraleitende Schichten (4) von miteinander verbundenen Bandstücken (2, 7a, 7b, 8a, 8b, 15) durch eine oder mehrere normalleitende Schichten, nämlich
- eine oder mehrere edelmetallhaltige Schichten (5), insbesondere silberhaltige Schichten (5), und/oder
- eine oder mehrere kupferhaltige Schichten, insbesondere Kupferschichten (14c, 14d),
miteinander verbunden sind,
und wobei die Substrate (3) der Bandstücke (2, 7a, 7b, 8a, 8b, 15) aus Metall gefertigt sind, wobei mehrere der Bandstücke (2, 7a, 7b, 8a, 8b, 15) jeweils als ein verkettetes Bandstück (2) ausgebildet sind,
wobei ein jedes verkettete Bandstück (2) jeweils mit zwei weiteren Bandstücken (7a, 7b) derart verbunden ist, dass
- die supraleitenden Schichten (4) der beiden weiteren Bandstücke (7a, 7b) einerseits und des verketteten Bandstücks (2) andererseits einander zugewandt sind, und
- die weiteren Bandstücke (7a, 7b) zusammen mit wenigstens 95% der gesamten Länge (L) des verketteten Bandstücks (2) überlappen,
wobei die Supraleiterstruktur (1) wenigstens N aufeinanderfolgende, verkettete Bandstücke (2) umfasst, mit N ≥ 5, derart, dass zumindest eines der weiteren Bandstücke (7a, 7b) zu einem jeden der aufeinanderfolgenden, verketteten Bandstücke (2) seinerseits eines der aufeinanderfolgenden, verketteten Bandstücke (2) ist,
wobei die verketteten Bandstücke (2) jeweils eine Länge (L) von wenigstens 100 m aufweisen,
und wobei die Supraleiterstruktur (1) eine Gesamtlänge von wenigstens 1000 m, bevorzugt wenigstens 2000 m aufweist.

2. Supraleiterstruktur (1) nach Anspruch 1, **dadurch gekennzeichnet, dass** N ≥ 20.

3. Supraleiterstruktur (1) nach Anspruch 1 oder 2, **dadurch gekennzeichnet, dass** die Supraleiterstruktur (1) über die aufeinanderfolgenden, verketteten Bandstücke (2) in Erstreckungsrichtung (x) der Bandstücke (2) periodisch ausgebildet ist.

4. Supraleiterstruktur (1) nach einem der vorhergehenden Ansprüche,
**dadurch gekennzeichnet, dass** die Supraleiterstruktur (1) zwei randseitige Bandstücke (8a, 8b) aufweist,
wobei ein randseitiges Bandstück (8a, 8b) jeweils mit einem verketteten Bandstück (2) derart verbunden ist, dass die supraleitenden Schichten (4) des randseitigen Bandstücks (8a, 8b) einerseits und des verketteten Bandstücks (2) andererseits einander zugewandt sind, und dass das verkettete Bandstück (2) im Wesentlichen mit der gesamten Länge des randseitigen Bandstücks (8a, 8b) überlappt.

5. Supraleiterstruktur (1) nach einem der vorhergehenden Ansprüche,
**dadurch gekennzeichnet, dass** die beiden weiteren Bandstücke (7a, 7b) zusammen mit wenigstens 99% der gesamten Länge (L) eines verketteten Bandstücks (2) überlappen.

6. Supraleiterstruktur (1) nach einem der vorhergehenden Ansprüche, **dadurch gekennzeichnet, dass** die verketteten Bandstücke (2) jeweils eine Länge (L) von wenigstens 200 m aufweisen.

7. Supraleiterstruktur (1) nach einem der vorhergehenden Ansprüche, **dadurch gekennzeichnet, dass** die Supraleiterstruktur (1) eine Gesamtlänge von wenigstens 2000 m aufweist.

8. Supraleiterstruktur (1) nach einem der vorhergehenden Ansprüche, **dadurch gekennzeichnet, dass** ein Spalt (6) zwischen zwei weiteren Bandstücken (7a, 7b), die mit demselben verketteten Bandstück (2) verbunden sind, eine Spaltbreite (SP) in Erstreckungsrichtung (x) der Bandstücke (7a, 7b) von 5mm oder weniger, bevorzugt 2mm oder weniger aufweist, insbesondere wobei der Spalt (6) bei aneinander anstoßenden weiteren Bandstücken (7a, 7b) geschlossen ausgebildet ist.

9. Supraleiterstruktur (1) nach einem der vorhergehenden Ansprüche, **dadurch gekennzeichnet, dass** ein Spalt (6) zwischen zwei weiteren Bandstücken (7a, 7b), die mit demselben verketteten Bandstück (2) verbunden sind, näherungsweise mittig bezüglich der Länge (L) dieses verketteten Bandstücks (2) angeordnet ist.

10. Supraleiterstruktur (1) nach einem der vorhergehenden Ansprüche, **dadurch gekennzeichnet, dass** die einander gegenüberliegenden Enden (10a, 10b) von zwei weiteren Bandstücken (7a, 7b), die mit demselben verketteten Bandstück (2) verbunden sind, sich jeweils auf das andere weitere Bandstück (7b; 7a) zu verjüngen,
insbesondere so dass ein Spalt (6) zwischen diesen zwei weiteren
Bandstücken (7a, 7b) zumindest abschnittsweise mit einem Winkel (α) zwischen 5° und 30° zur Erstreckungsrichtung (x) der Bandstücke (7a, 7b) verläuft.

11. Supraleiterstruktur (1) nach einem der vorhergehenden Ansprüche, **dadurch gekennzeichnet, dass** die Bandstücke (2, 7a, 7b, 8a, 8b, 15) der Supraleiterstruktur (1) außenseitig mit einer Shunt-Struktur (12) versehen sind, insbesondere teilweise oder vollständig von einer Shunt-Schicht (14; 14a, 14b) umhüllt sind.

12. Supraleiterstruktur (1) nach Anspruch 11, **dadurch gekennzeichnet,**
**dass** jeweils zwei Bandstücke (2, 7a, 7b, 8a, 8b, 15), die mit einander zugewandten supraleitenden Schichten (4) miteinander verbunden sind, quer zur Erstreckungsrichtung (x) der Bandstücke (2, 7a, 7b, 8a, 8b, 15) in einem oder mehreren Überstandbereichen (13, 13a) nicht überlappen, und dass die Shunt-Struktur (12) in mindestens einem besagten Überstandbereich (13, 13a) das zugehörige Bandstück (2, 7a, 7b, 8a, 8b, 15) kontaktiert.

13. Supraleiterstruktur (1) nach einem der vorhergehenden Ansprüche, **dadurch gekennzeichnet, dass** die supraleitende Schicht (4) ein Hochtemperatur-Supraleitermaterial, insbesondere YBCO oder BSCCO, enthält.

14. Supraleiterstruktur (1) nach einem der vorhergehenden Ansprüche, **dadurch gekennzeichnet, dass** zwischen Substrat (3) und supraleitender Schicht (4) eine Pufferschicht (9), insbesondere enthaltend CeO2, angeordnet ist.

15. Supraleiterstruktur (1) nach einem der vorhergehenden Ansprüche, **dadurch gekennzeichnet, dass** die Substrate (3) der Bandstücke (2, 7a, 7b, 8a, 8b, 15) aus Stahlblech gefertigt sind.

## Claims

1. Superconductor structure (1) comprising a plurality of band segments (2, 7a, 7b, 8a, 8b, 15) of band-shaped superconductor,
wherein each band segment (2, 7a, 7b, 8a, 8b, 15) comprises a substrate (3) and a superconducting layer (4) deposited thereon,
wherein the band segments (2, 7a, 7b, 8a, 8b, 15) are joined to one another with mutually facing superconducting layers (4),
wherein mutually facing superconducting layers (4) of joined band segments (2, 7a, 7b, 8a, 8b, 15) are joined to one another by one or more normally conducting layers, namely
- one or more layers (5) containing a noble metal, in particular silver-containing layers (5) and/or
- one or more copper-containing layers, in particular copper layers (14c, 14d), and wherein the substrates (3) of the band segments (2, 7a, 7b, 8a, 8b, 15) are produced from metal,
wherein
a plurality of the band segments (2, 7a, 7b, 8a, 8b, 15) are each constituted as a linked band segment (2),
wherein each linked band segment (2) is joined to two further band segments (7a, 7b) such that
- the superconducting layers (4) of the two further band segments (7a, 7b) on the one hand and of the linked band segment (2) on the other hand face one another, and
- the further band segments (7a, 7b) together overlap at least 95% of the overall length (L) of the linked band segment (2),
wherein
the superconductor structure (1) comprises at least N sequential linked band segments (2) with N≥5 such that at least one of the further band segments (7a, 7b) associated with each one of the sequential linked band segments (2) is itself one of the sequential linked band segments (2),
wherein
the linked band segments (2) each have a length (L) of at least 100m and wherein
the superconductor structure (1) has an overall length of at least 1000m, preferably at least 2000 m.

2. Superconductor structure (1) according to claim 1, **characterized in that** N≥20.

3. Superconductor structure (1) according to claim 1 or 2, **characterized in that** the superconductor structure (1) is constituted periodically along the sequential linked band segments (2) in the direction of extension (x) of the band segments (2).

4. Superconductor structure (1) according to any one of the preceding claims, **characterized in that** the superconductor structure (1) comprises two peripheral band segments (8a, 8b),
wherein a peripheral band segment (8a, 8b) is joined in each case to a linked band segment (2) such that the superconducting layers (4) of the peripheral band segment (8a, 8b) on the one hand and of the linked band segment (2) on the other hand face each other and that the linked band segment (2) substantially overlaps the overall length of the peripheral band segment (8a, 8b).

5. Superconductor structure (1) according to any one of the preceding claims, **characterized in that** the two further band segments (7a, 7b) together overlap at least 99% of the overall length (L) of a linked band segment (2).

6. Superconductor structure (1) according to any one of the preceding claims, **characterized in that** the linked band segments (2) each have a length (L) of at least 200m.

7. Superconductor structure (1) according to any one of the preceding claims, **characterized in that** the superconductor structure (1) has an overall length of at least 2000m.

8. Superconductor structure (1) according to any one of the preceding claims, **characterized in that** a gap (6) between two further band segments (7a, 7b), which are joined to the same linked band segment (2), has a gap width (SP) in the direction of extension (x) of the band segments (7a, 7b) of 5mm or less, preferably 2mm or less, in particular wherein the gap (6) is constituted to be closed with abutting further band segments (7a, 7b).

9. Superconductor structure (1) according to any one of the preceding claims, **characterized in that** a gap (6) between two further band segments (7a, 7b), which are joined to the same linked band segment (2), is disposed approximately centrally with respect to the length (L) of this linked band segment (2).

10. Superconductor structure (1) according to any one of the preceding claims, **characterized in that** the opposing ends (10a, 10b) of two further band segments (7a, 7b), which are joined to the same linked band segment (2), each taper towards the other further band segment (7b; 7a),
in particular such that a gap (6) between these two further band segments (7a, 7b) extends at least in sections with an angle (α) of between 5° and 30° with respect to the direction of extension (x) of the band segments (7a, 7b).

11. Superconductor structure (1) according to any one of the preceding claims, **characterized in that** the band segments (2, 7a, 7b, 8a, 8b, 15) of the superconductor structure (1) are provided on the outside with a shunt structure (12), in particular are partially or completely enveloped in a shunt layer (14; 14a, 14b).

12. Superconductor structure (1) according to claim 11, **characterized in that** in each case two band segments (2, 7a, 7b, 8a, 8b, 15) which are joined to one another with mutually facing superconducting layers (4) do not overlap transversely to the direction of extension (x) of the band segments (2, 7a, 7b, 8a, 8b, 15) in one or more protrusion areas (13, 13a), and that the shunt structure (12) contacts the associated band segment (2, 7a, 7b, 8a, 8b, 15) in at least one said protrusion area (13, 13a).

13. Superconductor structure (1) according to any one of the preceding claims, **characterized in that** the superconducting layer (4) contains a high-temperature superconducting material, in particular YBCO or BSCCO.

14. Superconductor structure (1) according to any one of the preceding claims, **characterized in that** a buffer layer (9), in particular containing CeO2, is disposed between the substrate (3) and the superconducting layer (4).

15. Superconductor structure (1) according to any one of the preceding claims, **characterized in that** the substrates (3) of the band segments (2, 7a, 7b, 8a, 8b, 15) are produced from steel sheet.

## Revendications

1. Structure supraconductrice (1), comprenant plusieurs morceaux de bande (2, 7a, 7b, 8a, 8b, 15) de supraconducteur en forme de bande,
sachant que chaque morceau de bande (2, 7a, 7b, 8a, 8b, 15) présente un substrat (3) et une couche supraconductrice (4) déposée dessus,
sachant que les morceaux de bande (2, 7a, 7b, 8a, 8b, 15) sont reliés aux couches supraconductrices (4) en face l'une de l'autre,
sachant que les couches supraconductrices (4) en face l'une de l'autre des morceaux de bande (2, 7a, 7b, 8a, 8b, 15) reliés entre eux sont reliées entre elles par une ou plusieurs couches normalement conductrices, à savoir
- une ou plusieurs couches contenant des métaux précieux (5), notamment des couches contenant de l'argent (5) et/ou
- une ou plusieurs couches contenant du cuivre, notamment des couches de cuivre (14c, 14d).
et sachant que les substrats (3) des morceaux de bande (2, 7a, 7b, 8a, 8b, 15) sont constitués de métal,
sachant que plusieurs morceaux de bande (2, 7a, 7b, 8a, 8b, 15) sont conçus chacun sous forme de morceau de bande concaténé (2),
sachant que chaque morceau de bande concaténé (2) est relié respectivement à deux autres morceaux de bande (7a, 7b) de manière à ce que
- les couches supraconductrices (4) des deux autres morceaux de bande (7a, 7b) d'une part et du morceau de bande concaténé (2) d'autre part sont en face l'une de l'autre, et
- les autres morceaux de bande (7a, 7b) chevauchent ensemble au moins 95 % de la longueur totale **(L)** du morceau de bande concaténé (2),
sachant que la structure supraconductrice (1) comprend au moins N morceaux de bande concaténés (2) successifs, où N ≥ 5, de sorte qu'au moins un des autres morceaux de bande (7a, 7b) constitue pour chacun des morceaux de bande concaténés (2) successifs un des morceaux de bande concaténés (2) successifs, sachant que les morceaux de bande concaténés (2) présentent chacun une longueur (L) d'au moins 100 m,
et sachant que la structure supraconductrice (1) présente une longueur totale d'au moins 1 000 m, de préférence au moins 2 000 m.

2. Structure supraconductrice (1) selon la revendication 1, **caractérisée en ce que** N ≥ 20.

3. Structure supraconductrice (1) selon la revendication 1 ou 2, **caractérisée en ce que** la structure supraconductrice (1) est constituée périodiquement sur les morceaux de bande concaténés (2) successifs dans le sens d'extension (x) des morceaux de bande (2).

4. Structure supraconductrice (1) selon une des revendications précédentes, **caractérisée en ce que** la structure supraconductrice (2) présente deux morceaux de bande situés au bord (8a, 8b),
sachant qu'un morceau de bande (8a, 8b) situé au bord est relié respectivement à un morceau de bande concaténé (2) de sorte à ce que les couches supraconductrices (4) du morceau de bande situé au bord (8a, 8b) d'une part et celles du morceau de bande concaténé (2) d'autre part se font face les unes aux autres et que le morceau de bande concaténé (2) chevauche essentiellement la longueur totale du morceau de bande situé au bord (8a, 8b).

5. Structure supraconductrice (1) selon une des revendications précédentes, **caractérisée en ce que** les deux autres morceaux de bande (7a, 7b) chevauchent ensemble au moins 99 % de la longueur totale (L) d'un morceau de bande concaténé (2).

6. Structure supraconductrice (1) selon une des revendications précédentes, **caractérisée en ce que** les morceaux de bande concaténés (2) présentent respectivement une longueur (L) d'au moins 200 m.

7. Structure supraconductrice (1) selon une des revendications précédentes, **caractérisée en ce que** la structure supraconductrice (1) présente une longueur totale d'au moins 2 000 m.

8. Structure supraconductrice (1) selon une des revendications précédentes, **caractérisée en ce qu'**une fente (6) entre deux autres morceaux de bande (7a, 7b) qui sont reliés au même morceau de bande concaténé (2) présente une largeur de fente (SP) dans le sens d'extension (x) des morceaux de bande (7a, 7b) de 5 mm ou moins, de préférence 2 mm ou moins, notamment sachant que la fente (6) est fermée pour les autres morceaux de bande (7a, 7b) aboutés les uns aux autres.

9. Structure supraconductrice (1) selon une des revendications précédentes, **caractérisée en ce qu'**une fente (6) entre deux autres morceaux de bande (7a, 7b) reliés au même morceau de bande concaténé (2) est disposée approximativement au centre par rapport à la longueur (L) de ce morceau de bande concaténé (2).

10. Structure supraconductrice (1) selon une des revendications précédentes, **caractérisée en ce que** les extrémités opposées (10a, 10b) des deux autres morceaux de bande (7a, 7b) qui sont reliés au même morceau de bande concaténé (2) se rétrécissent respectivement sur l'autre morceau de bande (7b ; 7a).
notamment de telle sorte qu'une fente (6) entre ces deux autres morceaux de bande (7a, 7b) s'étend au moins partiellement à un angle (α) compris entre 5° et 30° par rapport au sens d'extension (x) des morceaux de bande (7a, 7b).

11. Structure supraconductrice (1) selon une des revendications précédentes, **caractérisée en ce que** les morceaux de bande (2, 7a, 7b, 8a, 8b, 15) de la structure supraconductrice (1) sont pourvus côté extérieur d'une structure shunt (12), sont notamment enveloppés partiellement ou complètement par une couche shunt (14 ; 14a, 14b).

12. Structure supraconductrice (1) selon la revendication 11, **caractérisée en ce que** respectivement deux morceaux de bande (2, 7a, 7b, 8a, 8b, 15) reliés entre eux par des couches supraconductrices (4) en face l'une de l'autre ne chevauchent pas dans une ou plusieurs zones en saillie (13, 13a) transversalement au sens d'extension (x) des morceaux de bande (2, 7a, 7b, 8a, 8b, 15) et que la structure shunt (12) touche, dans au moins une desdites zones en saillie (13, 13a) le morceau de bande associé (2, 7a, 7b, 8a, 8b, 15).

13. Structure supraconductrice (1) selon une des revendications précédentes, **caractérisée en ce que** la couche supraconductrice (4) contient un matériau supraconducteur à haute température, notamment YBCO ou BSCCO.

14. Structure supraconductrice (1) selon une des revendications précédentes, **caractérisée en ce qu'**une couche tampon (9) contenant notamment du CeO2 est disposée entre le substrat (3) et la couche supraconductrice (4).

15. Structure supraconductrice (1) selon une des revendications précédentes, **caractérisée en ce que** les substrats (3) des morceaux de bande (2, 7a, 7b, 8a, 8b, 15) sont constitués de tôle forte.
